# EUROPEAN PATENT APPLICATION

(11) **EP 3 386 100 A2**
(43) Date of publication of application: **10.10.2018**
(21) Application number: 18187773.9
(22) Date of filing: 07.08.2018
(51) Int. Cl.: H02S 30/20, H02S 20/00, H01L 31/048

(54) **SOLAR POWER GENERATION APPARATUS**

(30) Priority: 29.01.2018 CN 201820147919 U
(71) Applicant: Beijing Juntai Innovation Technology Co., Ltd, 100176 Beijing (CN)
(72) Inventor: YANG, Xiuqing, BEIJING (CN); PENG, Fuguo, BEIJING (CN); HU, Dezheng, BEIJING (CN); XU, Xixiang, BEIJING (CN); LI, Yuanmin, BEIJING (CN)
(74) Representative: Cabinet Beau de Loménie

(57) **Abstract**

The present disclosure discloses a solar power generation apparatus, including: at least two substrates (10), two adjacent substrates being in flexible connection; and a solar cell chip (20). Each of the substrates (10) is provided with the solar cell chip (20). The flexible connection indicates that two adjacent substrates can rotate within a scope of 0-360 degrees, such that the at least two substrates in flexible connection have a plurality of states including a tiled state, a folding state, and states ranging from an unfolding state to the folding state. By arranging a solar cell chip (20) and a light-transmitting front plate (30) on a substrate (10), the power generation apparatus implements rolling up and housing the solar cell chip (20), and makes it easy to carry by a user. Moreover, by arranging a tin-coated copper tape, the solar power generation apparatus implements series connection of the solar cell chips on the substrates. Furthermore, by arranging an encapsulation film layer (50) on the solar cell chip (20), protection of the solar cell chip is implemented, and the service life of the solar cell chip is prolonged.

## Description

This application claims the benefit and priority of Patent Application No. 2018201479197 filed in China on January 29, 2018, the entire contents of which are incorporated herein by reference.

### TECHNICAL FIELD

The present disclosure relates to the field of solar power generation technologies, and more particularly, to a solar power generation apparatus.

### BACKGROUND

With the rapid development of solar power generation technologies, more and more solar energy products are integrated into our life, among which, a-Si/c-Si heterojunction (SHJ) solar cells characterized by high efficiency, high stability and low cost per kilowatt-hour are expected to become one of future mainstream photovoltaic technologies. The SHJ cells are characterized by low temperature coefficient, high environmental stability and double-sided power generation, their actual power generation capacity being higher, by 25% or so, than conventional crystalline silicon cells. In life nowadays, although the solar cells have been relatively widely used in large-scale industrial products, the solar cells are poor in portability and housing performance since they are formed by fixedly connecting a plurality of tabulate power generation units.

### SUMMARY

To solve the above problems, the present disclosure provides a solar power generation apparatus, which includes: at least two substrates flexibly connecting with each other, wherein the at least two substrates are capable to rotate within a scope of 0-360 degrees with respect to each other to have a state selected from the group consisting of a tiled state, a folding state, and one state of various states from an unfolding state to the folding state; and a solar cell chip provided on each of the at least two substrates.

Alternatively, the solar power generation apparatus as mentioned above further includes a light-transmitting front plate covering the solar cell chip.

In the solar power generation apparatus as mentioned above, alternatively, a material of the at least two substrates is selected from at least one of a plant material, a metal material, a carbon fiber, and a synthetic macromolecular polymer.

In the solar power generation apparatus as mentioned above, alternatively, each of the at least two substrates is provided with a groove or a through groove, and the solar cell chip is arranged in the groove or the through groove.

In the solar power generation apparatus as mentioned above, alternatively, each of the at least two substrates has a front surface and a back surface, and each of the front surface and the back surface is provided with the solar cell chip.

Alternatively, the solar power generation apparatus as mentioned above further comprising a light-transmitting back plate and a light-transmitting front plate, wherein the light-transmitting back plate covers the solar cell chip arranged on the back surface of each of the at least two substrates; and the light-transmitting front plate covers the solar cell chip arranged on the front surface of each of the at least two substrates.

In the solar power generation apparatus as mentioned above, alternatively, further comprising a light-transmitting back plate covering the solar cell chip, and the light-transmitting back plate and the light-transmitting front plate are respectively positioned on two opposite sides of the substrate when the solar cell chip is arranged in the through groove.

In the solar power generation apparatus as mentioned above, alternatively, two adjacent solar cell chips are connected in series with each other by a welding strip.

In the solar power generation apparatus as mentioned above, alternatively, an encapsulation adhesive film is provided between the solar cell chip and the light-transmitting front plate; and an encapsulation adhesive film is provided between the solar cell chip and the substrate.

In the solar power generation apparatus as mentioned above, alternatively, the encapsulation adhesive film is one of an ethylene-vinyl acetate (EVA) adhesive film, a polyolefin elastomer (POE) adhesive film, and a polyvinyl butyral (PVB) adhesive film.

In the solar power generation apparatus as mentioned above, alternatively, the light-transmitting front plate or the light-transmitting back plate is selected from at least one of an ethylene-tetrafluoroethylene copolymer (ETFE) film, a polyvinyl chloride (PVC) film and a polyethylene terephthalate (PET) film, or is a composite film composited by at least one of the ETFE film, the PVC film and the PET film and an ultraviolet (UV) barrier film or a water-blocking film.

In the solar power generation apparatus as mentioned above, alternatively, the solar cell chip is a double-sided power generation solar cell chip.

In the solar power generation apparatus as mentioned above, alternatively, the double-sided power generation solar cell chip is a heterojunction with intrinsic thin layer solar cell chip (referred to as heterojunction solar cell chip).

In the solar power generation apparatus as mentioned above, alternatively, the solar cell chips are connected in series.

Alternatively, the solar power generation apparatus as mentioned above further includes a power output interface, which is connected in series with the solar cell chip.

Alternatively, the solar power generation apparatus as mentioned above is a bamboo slip type solar power generation apparatus.

To solve the above problems, there is also provided a solar power generation apparatus, which includes: at least two bamboo boards, connected with each other; and at least two solar cell chips. Two adjacent solar cell chips are connected in series with each other. Each of the solar cell chips is correspondingly arranged on each of the bamboo boards.

Alternatively, the solar power generation apparatus as mentioned above includes a transparent front plate, which is arranged on a side of the solar cell chip diverging from the bamboo board.

In the solar power generation apparatus as mentioned above, alternatively, each of the bamboo boards is provided with a through hole suitable for reeving a rope, and the bamboo boards are configured to work in coordination with each other by way of the through holes and the ropes.

In the solar power generation apparatus as mentioned above, alternatively, two adjacent solar cell chips are connected in series with each other by way of a tin-coated copper tape.

In the solar power generation apparatus as mentioned above, alternatively, an encapsulation adhesive film is further provided between the solar cell chip and the transparent front plate.

In the solar power generation apparatus as mentioned above, alternatively, an encapsulation adhesive film is further provided between the solar cell chip and the bamboo board.

In the solar power generation apparatus as mentioned above, alternatively, the bamboo board is provided with a groove, and the solar cell chip is fixedly embedded into the groove.

In the solar power generation apparatus as mentioned above, alternatively, an encapsulation adhesive film is further provided between the solar cell chip and the groove.

In the solar power generation apparatus as mentioned above, alternatively, the encapsulation adhesive film is selected from at least one of an EVA adhesive film, a POE adhesive film, and a PVB adhesive film.

In the solar power generation apparatus as mentioned above, alternatively, the solar cell chip is a heterojunction solar cell chip.

By arranging a solar cell chip on a bamboo slip type bamboo board or substrate, the solar power generation apparatus provided by the present disclosure implements rolling up and housing the solar cell chip, and makes it easy to carry by a user. Moreover, by arranging a tin-coated welding strip or a welding strip, the solar power generation apparatus implements series connection of the solar cell chips on the bamboo boards, and also makes it easy to supply power for electric equipment. Furthermore, by arranging an encapsulation layer such as an encapsulation adhesive film or a light-transmitting front plate on the solar cell chip, protection of the solar cell chip is implemented, and the service life of the solar cell chip is prolonged.

### BRIEF DESCRIPTION OF THE DRAWINGS

FIG. 1 is a schematic structural diagram of a solar power generation apparatus according to an embodiment of the present disclosure;
FIG. 2 is a cutaway view of the solar power generation apparatus according to an embodiment of the present disclosure;
FIG. 3 is a sectional view of the solar power generation apparatus according to an embodiment of the present disclosure;
FIG. 4 is a sectional view of the solar power generation apparatus according to another embodiment of the present disclosure;
FIG. 5 is a schematic sectional view of the solar power generation apparatus according to still another embodiment of the present disclosure; and
FIG. 6 is a schematic sectional view of the solar power generation apparatus according to still another embodiment of the present disclosure.

### BEST MODE FOR CARRYING OUT THE INVENTION

The embodiments of the disclosure will be described in detail as below. Examples of the embodiments are as shown in drawings, in which same or similar reference numbers always represent same or similar elements or elements with same or similar functions. The embodiments described with reference to the drawings are exemplary, just used for explaining the disclosure, not for limiting the disclosure.

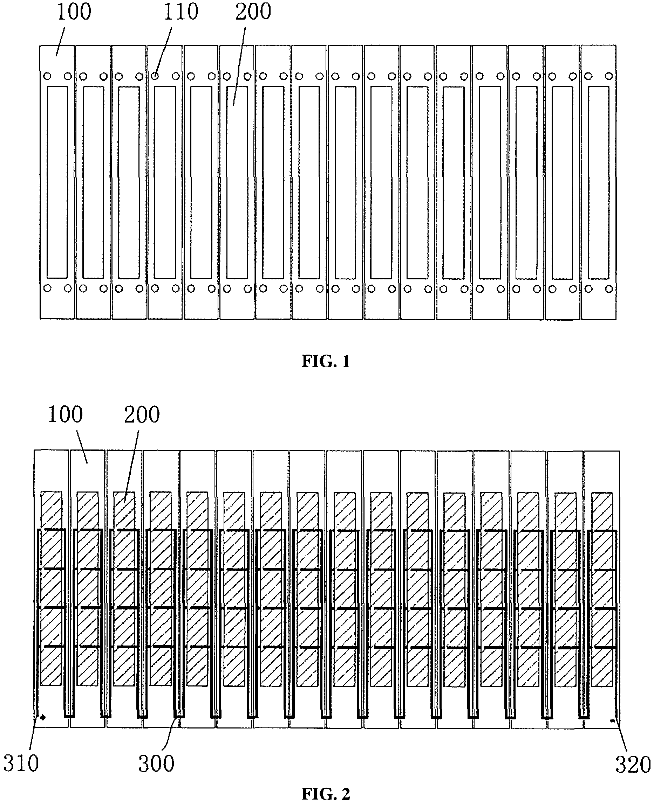

As shown in FIG. 1, an embodiment of the present disclosure provides a solar power generation apparatus, which includes at least two bamboo boards 100, a solar cell chip layer, and a transparent front plate 400. The solar cell chip layer includes at least two solar cell chips 200, and two adjacent solar cell chips 200 are connected in series with each other. Each of the bamboo boards 100 is provided with a through hole 110 used for reeving a rope, and the bamboo boards 100 cooperates and connects with each other by way of the through holes 110 and the ropes. Each of the solar cell chips 200 is arranged on each of the bamboo boards 100, and each of the solar cell chips 200 is corresponding to each of the bamboo boards 100 one by one. The transparent front plate 400 is arranged on a side of the solar cell chip 200 diverging from the bamboo board 100.

The bamboo boards 100 are connected to each other by ropes. Therefore, the solar power generation apparatus may be rolled up, like rolling up bamboo slips, and housed, thereby saving occupied space and making it easy to carry around. When it is required to charge electric equipment using the solar power generation apparatus, the solar power generation apparatus may be unfolded and kept in the sun. Solar energy is converted into electric energy by the solar cell chip 200, and the electric energy is outputted to the electric equipment. In this way, supplying power for the electric equipment is implemented.

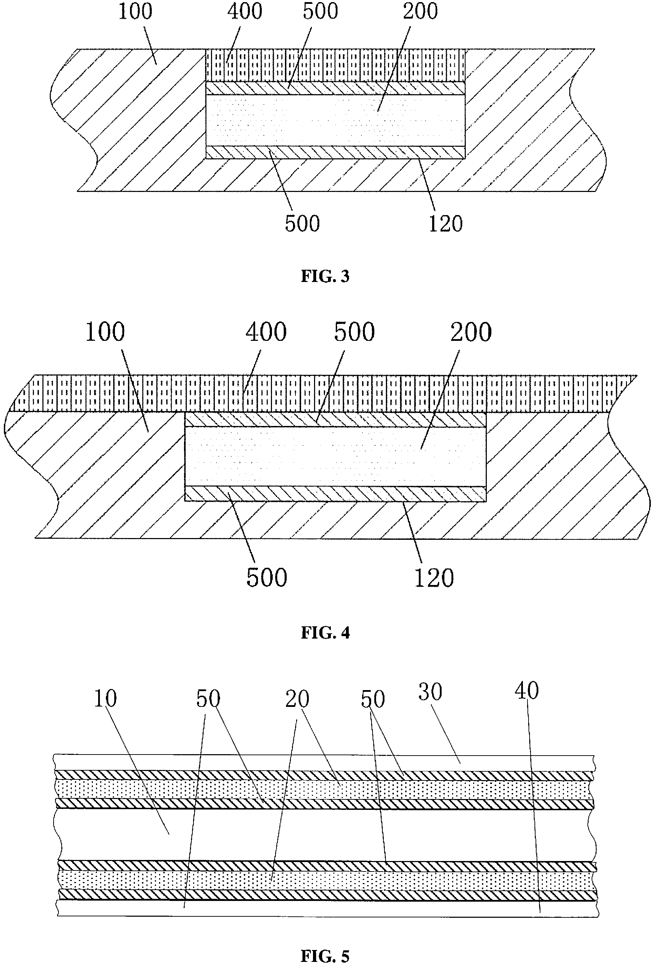

It is to be noted that to make it possible to roll up, like rolling up bamboo slips, the solar power generation apparatus into a cylindric shape, the transparent front plate 400 may be designed into an integrative structure. That is, a whole piece of transparent front plate 400 is covered on all the solar cell chips 200, as shown in FIG. 3. The transparent front plate 400 has a certain flexibility, which may allow the solar power generation apparatus to be rolled up, and also may prevent from damaging the series circuits between the solar cell chips 200 due to folding the bamboo boards 100.

Of course, the transparent front plate 400 also may be a film layer having an integrative structure that can be covered on all the bamboo boards 100, as shown in FIG. 4, which may guarantee the encapsulation of the solar cell chip 200, make the solar power generation apparatus look more beautiful, and also provide users with better experience.

Further, as shown in FIG. 2, in this embodiment, the number of the bamboo boards 100 is 16, and the solar cell chips 200 on each of the bamboo boards 100 are connected in series with each other by way of a tin-coated copper tape.

Specifically, a tin-coated copper tape 300 on each solar cell chip 200 has a positive leading-out terminal and a negative leading-out terminal. For two adjacent solar cell chips 200, the positive leading-out terminal of one solar cell chip 200 is connected to the negative leading-out terminal of the other solar cell chip 200. In this way, series connection of the solar cell chips 200 on all the bamboo boards 100 may be implemented. Also, for the solar cell chips 200 arranged on the bamboo boards 100 at two ends of the solar power generation apparatus, each of the solar cell chips 200 is respectively provided, in idle, with a positive leading-out terminal 310 and a negative leading-out terminal 320 to connect the electric equipment. In this way, supplying power for the electric equipment may be implemented.

Further, as shown in FIG. 3 or FIG. 4, the bamboo board 100 may be provided with a groove 120, and the solar cell chip 200 is fixedly embedded into the groove 120. When it is required to use the solar cell chip 220 for photoelectric conversion, the solar power generation apparatus may be unfolded, such that the solar cell chip 200 receives sunshine. When the solar power generation apparatus is rolled up and housed, the solar cell chips 200 may be housed in the solar power generation apparatus after the solar power generation apparatus is rolled up because the groove 120 does not penetrate through the bamboo board 100, such that the solar cell chips 200 may be prevented from being damaged by external factors when the solar cell chips 200 are exposed to the outside environment.

Specifically, as shown in FIG. 3 or FIG. 4, the solar power generation apparatus may further include an encapsulation adhesive film 500. The back surface of the solar cell chip 200 is fixedly connected to the bottom surface of the groove 120 by way of the encapsulation adhesive film 500, and the front surface of the solar cell chip 200 is fixedly connected to the transparent front plate 400 by way of the encapsulation adhesive film 500. In this way, the reliability of encapsulating the solar cell chip 200 into the groove 120 may be ensured.

The encapsulation adhesive film 500 may be one of an ethylene-vinyl acetate (EVA) adhesive film, a polyolefin elastomer (POE) adhesive film, and a polyvinyl butyral (PVB) adhesive film. Of course, the encapsulation adhesive film 500 is not limited to the above adhesive films, and also may be a barrier layer of a composite material or may be other film layers having certain weathering resistance, insulativity, flame retardancy, high water resistance and oxygen resistance or fire resistance. In this embodiment, the encapsulation adhesive film 500 preferably is the EVA adhesive film.

The light-transmitting front plate 400 may be one of an ethylene tetrafluoroethylene (ETFE) film, a polyvinyl chloride (PVC) film and a polyethylene terephthalate (PET) film, or may be a composite film composited by any one of the ETFE film, the PVC film and the PET film and an ultraviolet (UV) barrier film or a water-blocking film.

It is to be understood that the solar cell chip 200 may be a monocrystalline silicon or polycrystalline silicon solar cell chip or the like, and also may be a copper indium gallium selenide (CIGS) solar cell chip, a copper indium diselenide solar cell chip, a cadmium telluride solar cell chip, a gallium arsenide solar cell chip, or a dye-sensitized solar cell chip, etc. In this embodiment, alternatively, the solar cell chip 200 is a double-sided power generation solar cell chip. Further, the double-sided power generation solar cell chip is a heterojunction solar cell chip. In the heterojunction solar cell chip, an n-type or p- type monocrystalline silicon wafer is used as a substrate, and then an intrinsic amorphous silicon film (i-a-Si:H) having a thickness of 5-10nm and a p-type amorphous silicon film (p-a-Si:H) having a thickness of 5-10nm are deposited, in sequence, in a front surface of an n-type c-Si textured and cleaned. In this way, a p-n heterojunction is formed. An i-a-Si:H film having a thickness of 5-10nm and an n-type amorphous silicon film (n-a-Si:H) having a thickness of 5-10nm are deposited, in sequence, in a back surface of the silicon wafer, such that a back surface field is formed. At the two sides doped with the a-Si:H film, a transparent conductive oxide (TCO) film is deposited, and finally a metal collector is formed on top layers at the two sides.

By arranging a solar cell chip on a bamboo board, the solar power generation apparatus provided by the embodiments of the present disclosure implements rolling up and housing the solar cell chip, and makes it easy to carry by a user. Moreover, by arranging a tin-coated copper tape or a copper tape, the solar power generation apparatus implements series connection of the solar cell chips on the bamboo boards, and also makes it easy to supply power for electric equipment. Furthermore, by arranging an encapsulation layer such as an encapsulation adhesive film or a light-transmitting front plate on the solar cell chip, protection of the solar cell chip is implemented, and the service life of the solar cell chip is prolonged.

As shown in FIG. 5, an embodiment of the present disclosure further provides a solar power generation apparatus, which includes a substrate 10, a solar cell chip 20, and a light-transmitting front plate 30. The number of the substrates 10 is at least two, and two adjacent substrates 10 are in flexible connection. When there are more than a dozen or even dozens of substrates 10, a power generation apparatus in an ancient bamboo slip type may be formed. Each of the substrates 10 is provided with the solar cell chip 20. The light-transmitting front plate 30 covers the solar cell chip 20, such that sunlight can transmit through the light-transmitting front plate 30 and shine on the solar cell chip 20 to implement the power generation function. The flexible connection indicates that two adjacent substrates 10 can rotate within a scope of 0-360 degrees, such that the solar power generation apparatus has a plurality of states including a tiled state, a folding state, and states ranging from an unfolding state to the folding state. The flexible connection is implemented by way of a connecting apparatus. In addition to connecting structures such as the ropes and through holes as mentioned above, the connecting apparatus may select a hinge connection, a shaft connection, a rigid-ring-and-through-hole collaborating structure connection, and a flexible adhesive tape connection, etc. All connection modes that can implement the above functions in the prior art may be applied to the embodiments of the present disclosure.

Further, in the embodiment of the present disclosure, a material of the substrate 10 is selected from a plant material, a metal material, a carbon fiber, or a synthetic macromolecular polymer. The plant material is bamboo, wood or paperboard, plant composite board, or synthetic board material including melamine board. Also a coating having patterns may be arranged on the surface of the substance 10. The coating has good visual effect and also may provide a protection for the substance 10, for example, moisture protection, resistance to abrasion, shock resistance, protection against insects, and corrosion protection, etc. The metal material includes an elemental metal such as iron or aluminum, and may also include various alloys. The macromolecular polymer includes polyolefin, polyester, polycarbonate, rubber, and so on. Preferably, the material of the substrate is the carbon fiber because it has good performances of light weight and shock resistance, etc.

As shown in FIG. 5, the substrate 10 has a front surface and a back surface. The front surface and the back surface herein refer to two areas of the substrate 10 including a front surface and a back surface. For example, a groove on any surface extending toward inside also belongs to the front surface or the back surface. The solar cell chip 20 may be arranged on the front surface or the back surface of the substrate 10. The solar cell chip 20 may be fixed to the substrate 10 by way of the encapsulation adhesive film 50. Further, both the front surface and the back surface of the substrate 10 is provided with the solar cell chip 20, such that a light receiving area of the solar power generation apparatus may be increased, and thus the power generation capacity is enhanced. The aforementioned tiled state may refer to a state where the front surfaces of all the substrates 10 are on the same plane. The folding state refers to a state where the front surfaces of adjacent substrates 10 are in parallel. The folding state and states ranging from an unfolding state to the folding state refer to a state, in which the plane where the front surface of one substrate 10 is and the planes where the front surfaces of adjacent substrates 10 are are neither in parallel nor on the same plane.

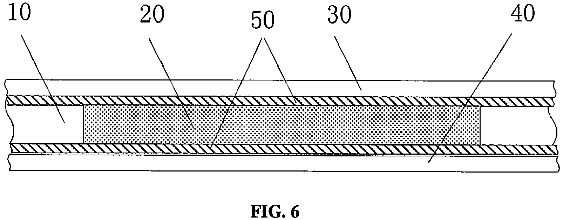

Moreover, in the embodiment of the present disclosure, the substrate 10 is provided with a groove or a through groove, and the solar cell chip 20 is arranged in the groove or the through groove. The groove is as shown in FIG. 3 and FIG. 4. As shown in FIG. 6, when the substrate 10 has a through groove, the through groove allows the front surface of the substrate 10 to communicate with the back surface of the substrate 10. The solar cell chip 20 arranged in the through groove can receive sunshine from the directions of both the two surfaces and implements power generation, such that the power generation capacity is enhanced, and the application convenience of the power generation apparatus is improved. In this case, a light-transmitting back plate 40 needs to be added, which is covered on the solar cell chip 20. The light-transmitting back plate 40 and the light-transmitting front plate 30 are respectively positioned on two opposite sides of the substrate 10 to protect the solar cell chip 20. The setting mode and means of the light-transmitting back plate 40 may adopt the same scheme as the light-transmitting front plate 30.

As mentioned in the preceding embodiments, the solar cell chips 20 are connected in series. Two adjacent solar cell chips 20 are connected in series using a welding strip such as a tin-coated copper tape. The solar cell chip 20, the light-transmitting front plate 30, the light-transmitting back plate 40 and the substrate 10 may be fixed by arranging an encapsulation adhesive film 50. Alternatively, the solar power generation apparatus further includes a power output interface, which is connected in series with the solar cell chip to supply power for external electric equipment. This interface may adopt a USB interface standard, etc.

In the solar power generation apparatus provided by the embodiments of the present disclosure, a power generation unit is constituted by a plurality of substrates. Two adjacent substrates adopt a flexible connection, such that they can rotate within a scope of 0-360 degrees. Therefore, it may be implemented that the substrates have a plurality of states including a tiled state, a folding state, and states ranging from an unfolding state to the folding state. The solar power generation apparatus may be unfolded when in use and folded when not in use, which increases the portability, transportation convenience or installation convenience of the solar power generation apparatus. Meanwhile, the power generation apparatus also can be rolled and folded in severe environment to protect the power generation apparatus against natural or man-made damage. The size of the solar power generation apparatus is not limited. That is, the specific size of the solar power generation apparatus may be determined based on usage scenarios. For example, in one usage scenario, the solar power generation apparatus may appear as a small-sized portable power generation apparatus; and in another scenario, the solar power generation apparatus may appear as larger rolling shutters of doors and windows or venetian blinds. Moreover, the solar power generation apparatus may appear as a top cover layer applied to roofs or agricultural greenhouses, where the solar power generation apparatus can be adjusted in the amount of incident light and used for power generation. Furthermore, the solar power generation apparatus may appear as a power generation unit of a large-scaled photovoltaic power plant or a power generation module of a distributed photovoltaic power station.

The above embodiments as shown in the drawings illustrate the structure, the features and the effects of the solar power generation apparatus in detail, and the above embodiments are merely preferred embodiments of the present disclosure. However, the present disclosure does not limit the scope of implementation according to what is shown in the figures. Any modifications made in accordance with the conception of the present disclosure or equivalent embodiments revised as equivalent changes shall fall within the scope of protection of the present disclosure as long as they are within the spirit of the specification and the spirit covered by the drawings.

## Claims

1. A solar power generation apparatus, comprising:
at least two substrates (10) flexibly connecting with each other, wherein the at least two substrates (10) are capable to rotate within a scope of 0-360 degrees with respect to each other to have a state selected from the group consisting of a tiled state, a folding state, and one state of various states from an unfolding state to the folding state; and
a solar cell chip (20) provided on each of the at least two substrates (10).

2. The solar power generation apparatus according to claim 1, comprising a light-transmitting front plate (30) covering the solar cell chip (20).

3. The solar power generation apparatus according to claim 1 or 2, wherein a material of the at least two substrates (10) is selected from at least one of a plant material, a metal material, a carbon fiber, and a synthetic macromolecular polymer.

4. The solar power generation apparatus according to claim 1, wherein
each of the at least two substrates (10) is provided with a groove or a through groove, and the solar cell chip (20) is arranged in the groove or the through groove.

5. The solar power generation apparatus according to claim 1, wherein
each of the at least two substrates (10) has a front surface and a back surface, and each of the front surface and the back surface is provided with the solar cell chip (20).

6. The solar power generation apparatus according to claim 5, further comprising a light-transmitting back plate (40) and a light-transmitting front plate (30), wherein the light-transmitting back plate (40) covers the solar cell chip (20) arranged on the back surface of each of the at least two substrates (10); and
the light-transmitting front plate (30) covers the solar cell chip (20) arranged on the front surface of each of the at least two substrates (10).

7. The solar power generation apparatus according to claim 4, further comprising a light-transmitting back plate (40) covering the solar cell chip (10), and the light-transmitting back plate (40) and the light-transmitting front plate (30) are respectively positioned on two opposite sides of the substrate (10) when the solar cell chip (20) is arranged in the through groove.

8. The solar power generation apparatus according to claim 1, wherein two adjacent solar cell chips (20) are connected in series with each other by a welding strip.

9. The solar power generation apparatus according to claim 2 or 6, wherein an encapsulation adhesive film (50) is provided between the solar cell chip (20) and the light-transmitting front plate (30); and an encapsulation adhesive film (50) is provided between the solar cell chip (20) and the substrate (10).

10. The solar power generation apparatus according to claim 6, wherein the light-transmitting front plate (30) or the light-transmitting back plate (40) is selected from at least one of an ethylene tetrafluoroethylene (ETFE) copolymer film, a polyvinyl chloride (PVC) film and a polyethylene terephthalate (PET) film, or is a composite film composited by at least one of the ETFE film, the PVC film and the PET film and an ultraviolet (UV) barrier film or a water-blocking film.

11. The solar power generation apparatus according to claim 1 or 4, wherein the solar cell chip (20) is a double-sided power generation solar cell chip.

12. The solar power generation apparatus according to claim 11, wherein the double-sided power generation solar cell chip is a heterojunction solar cell chip.

13. A solar power generation apparatus, comprising:
at least two bamboo boards (100), connected with each other; and
at least two solar cell chips (200), two adjacent solar cell chips being connected in series with each other;
each of the solar cell chips (200) being correspondingly arranged on each of the bamboo boards (100).

14. The solar power generation apparatus according to claim 13, comprising a transparent front plate (400), the transparent front plate (400) being arranged on a side of the solar cell chip (200) diverging from the bamboo board (100).

15. The solar power generation apparatus according to claim 13 or 14, wherein each of the bamboo boards (100) is provided with a through hole (110) suitable for reeving a rope, and the bamboo boards (100) are configured to work in coordination with each other by way of the through holes (110) and the ropes.
